# FASCICULE DE BREVET EUROPEEN

(11) **EP 1 804 250 B1**
(45) Date de publication et mention de la délivrance du brevet: **06.05.2009**
(21) Numéro de dépôt: 06292033.5
(22) Date de dépôt: 22.12.2006
(51) Int. Cl.: G11C 11/419

(54) **Dispositif de stockage muni de moyens de variation de la tension d'alimentation, de moyens de créer une surtension sur une ligne de bits, et procédé de mise en oeuvre**
Speichereinrichtung mit Mitteln zur Betriebsspannungsveränderung und zum Bitline-Boosten, und Betriebsverfahren
Memory device comprising means for varying the supply voltage and boosting the bit line, and operation method

(30) Priorité: 26.12.2005 FR 0513326
(43) Date de publication de la demande: 04.07.2007
(73) Titulaire: STMicroelectronics S.A., 92120 Montrouge (FR)
(72) Inventeur: Dray, Cyrille, 38000 Grenoble (FR); Jacquet, François, 38190 Frogues (FR); Barasinski, Sébastien, 38420 Meylan (FR)
(74) Mandataire: Bentz, Jean-Paul

(56) Documents cités:
- JP-A- 2005 071 491
- US-A- 5 726 944
- US-A- 6 147 898
- US-A1- 2005 105 344
- US-A1- 2005 141 289

## Description

La présente invention concerne de façon générale les dispositifs de stockage d'information à mémoire vive, et notamment les cellules de mémoire vive de type SRAM (static random-access memory).

Plus précisément, l'invention concerne un dispositif de stockage d'information à mémoires de type SRAM, alimenté par une tension (VDD), et comprenant :
- une matrice de cellules de base, organisées en colonnes de base et alimentées par une tension d'alimentation (VDDM), et
- des moyens de variation de la tension d'alimentation (VDDM) de la colonne de base d'une cellule de base sélectionnée pour le stockage d'information, les moyens de variation de la tension d'alimentation comprenant des moyens d'émulation d'une cellule de base. Un tel dispositif de stockage est connu du document US 2005/0141289 A1.

La puissance dynamique consommée par un dispositif est fonction du carré de sa tension d'alimentation. Dans un souci d'économie d'énergie, il est souhaitable que la tension d'alimentation soit basse.

Or les mémoires statiques sont très sensibles à la tension d'alimentation, une faible variation pouvant occasionner des erreurs, voire mettre en défaut le système entier. Par ailleurs, une tension d'alimentation trop faible conduit a une perte d'information, dès lors que la tension d'alimentation est en deçà de la valeur minimale de la tension de rétention de la mémoire.

Aussi, au sein d'un système complexe de type système sur puce (« System on Chip ») comprenant des mémoires embarquées de type SRAM, il s'agit de s'assurer que les performances en matière de réduction de consommation dynamique ne seront pas limitées par la ou les mémoires SRAM.

En outre, dans les dispositifs à matrice de cellules mémoires, la structure en colonnes impose que la tension d'alimentation (VDDM) d'une colonne soit la même pour toutes les cellules de la colonne. Cette structure impose aussi une logique de « maillon faible », c'est-à-dire que les propriétés de la cellule la plus contraignante influent sur toute la colonne la comportant, notamment par sa tension de rétention minimale.

Par ailleurs, une cellule mémoire permet de réaliser soit une opération de lecture soit une opération d'écriture, auxquelles on associe des marges d'opération. Ces marges sont appelées respectivement « Static Noise Margin » et « Write Margin » dans la littérature anglo-saxonne. Ces marges sont antagonistes.

Ainsi, plus la tension d'alimentation est faible, plus la marge d'opération est faible. Plus exactement, c'est la dispersion de la valeur de la marge qui est préjudiciable. En fait les marges sont relativement insensibles à la variation de la tension d'alimentation, mais des dispersions de plus en plus élevées conduisent à des problèmes de variation de plus en plus retreinte de la tension d'alimentation.

La présente invention se place dans le cadre des dispositifs permettant de réaliser des opérations d'écriture à basse tension, c'est-à-dire pour une technologie donnée, plus basse que la tension nominale. Par exemple, pour une tension nominale de 1,2V, réaliser des opérations d'écriture à 0,7V.

A l'heure actuelle, tous les systèmes visent à la baisse de la taille des mémoires. Or la baisse de la taille des composants augmente leur dispersion. En effet, il existe une forte variabilité électrique des transistors qui influe sur les marges à la lecture et à l'écriture d'une cellule mémoire.

L'alimentation d'une cellule mémoire dépend notamment des conditions PVT « Process Voltage Temperature » du système (circuit) la comprenant, c'est-à-dire des conditions du procédé technologique, de tension et de température.

A cause de ces contraintes (PVT, marges d'opération, déviations locales -mismatch en anglais ou desappariement-), il est nécessaire de faire varier la tension d'alimentation VDDM d'une cellule afin de favoriser la lecture ou l'écriture. Typiquement, une baisse de la tension d'alimentation favorise les opérations d'écriture, et inversement, une hausse de la tension d'alimentation favorise les opérations de lecture d'une cellule mémoire.

La présente invention se place dans le cadre des dispositifs visant à privilégier la marge à l'écriture, la lecture pouvant être fonctionnelle sur une large gamme de tension.

Un tel dispositif est connu de l'homme du métier, notamment par l'exemple qu'en donne le document US 6,954,396 de l'état de la technique antérieure.

Ce document décrit un dispositif comprenant des moyens pour sous volter la tension d'alimentation VDDM des cellules, de sorte à favoriser les opérations d'écriture, et des moyens pour survolter la tension d'alimentation VDDM des cellules, de sorte à favoriser les opérations de lecture. Ces moyens permettent d'établir des polarisations statiques pour les phases de lecture, écriture.

Les moyens nécessaires aux survoltages sont coûteux en énergie et vont à l'encontre de la baisse de consommation dynamique souhaitée.

La présente invention a pour but de remédier à ces inconvénients en proposant un dispositif visant à optimiser la tension d'alimentation VDDM nécessaire à l'écriture d'une cellule mémoire.
Avec cet objectif en vue, le dispositif selon l'invention, par ailleurs conforme à l'art antérieur connu du US 2005/0141289 cité ci-avant, est essentiellement caractérisé en ce que les moyens de variation de la tension d'alimentation (VDDM) d'une colonne de base comprennent .
- des moyens d'émulation, dans une colonne miroir comprenant au moins une cellule miroir munie de noeuds internes, de la cellule la plus contraignante de la colonne de base comprenant la cellule de base sélectionnée,
- des moyens de variation de la tension d'alimentation miroir de la colonne miroir, et
- des moyens pour recopier la tension d'alimentation miroir dans la colonne de base comprenant la cellule de base sélectionnée, à la détection du basculement de l'ensemble d'au moins une cellule miroir dans la colonne miroir.

De préférence, la colonne miroir comprend au moins une autre cellule miroir de sorte à constituer une pluralité P de cellules miroir mises en parallèle et un nombre N de transistors d'accès miroirs activés.

Les cellules miroir sont mises en parallèle par exemple par le partage d'une ligne de connexion aux mêmes noeuds internes (BLTiMOCK, BLFiMOCK).

Dans le mode de réalisation préféré, le rapport N/P entre le nombre de transistors d'accès miroirs activés et le nombre de cellules miroir mises en parallèle est fonction de la tension d'alimentation du dispositif de stockage.

A titre d'alternative, et de façon combinable, au moins une cellule miroir de la colonne miroir est une cellule SRAM comprenant des transistors d'accès et des transistors de coeur, dont la tension de seuil d'au moins l'un d'entre eux est différente de la tension de seuil d'un transistor de même type d'une cellule de base.

On entend par type, un transistor de type « accès » ou de type « de coeur », indépendamment de leur configuration NMOS ou PMOS.

De préférence, la tension de seuil des transistors d'accès d'une cellule mémoire est plus élevée que la tension de seuil des transistors d'accès d'une cellule de base.

En outre, de façon parallèle, les valeurs absolues des tensions de seuil des transistors du coeur d'une cellule miroir sont de préférence plus faibles que les valeurs absolues des tensions de seuil des transistors du coeur d'une cellule de base.

Avantageusement, une colonne miroir comprend plusieurs cellules miroir identiques entre elles. De préférence, les cellules miroir sont des cellules SRAM identiques aux cellules de base des colonnes de base.

De préférence, les moyens de variation de la tension d'alimentation miroir VDDMOCK comprennent une boucle de rétrocontrôle connectée à au moins l'un des noeuds internes (BLTiMOCK, BLFiMOCK).

L'invention concerne également un procédé de mise en oeuvre d'un dispositif de stockage d'informations à mémoires SRAM, organisées en matrice de cellules de base, comprenant les étapes consistant à :
- sélectionner une cellule de base d'une colonne de base pour le stockage d'information,
- émuler, dans une colonne miroir comprenant au moins une cellule miroir munie de noeuds internes, la cellule la plus contraignante en écriture de la colonne de base comprenant la cellule de base sélectionnée,
- appliquer à la colonne miroir une tension d'alimentation miroir initiale,
- diminuer progressivement la tension miroir initiale jusqu'à détecter le basculement de l'ensemble d'au moins une cellule miroir dans la colonne miroir,
- copier dans la colonne de base la tension miroir, et
- augmenter ensuite progressivement la tension d'alimentation miroir jusqu'à la tension miroir initiale.

Grâce à cet agencement, le dispositif selon l'invention permet de réaliser des opérations d'écriture à basse tension pour une mémoire SRAM.

Dans le mode de réalisation préféré, l'étape d'émulation comprend la mise en parallèle d'une pluralité P de cellules miroir.

La mise en parallèle est réalisée de préférence par le partage de lignes de connexion aux noeuds internes (BLFiMOCK, BLTiMOCK).

De préférence, les cellules miroir mises en parallèle sont sélectivement activées par N transistors d'accès.

A titre d'alternative, et de manière combinable, l'étape d'émulation comprend, pour au moins un transistor d'au moins une cellule miroir, la réalisation d'une tension de seuil différente de celle d'un transistor de même type d'une cellule de base.

De préférence, la tension de seuil des transistors d'accès d'une cellule mémoire est plus élevée que la tension de seuil des transistors d'accès d'une cellule de base.

En outre, de façon parallèle, les valeurs absolues des tensions de seuil des transistors du coeur d'une cellule miroir sont de préférence plus faibles que les valeurs absolues des tensions de seuil des transistors du coeur d'une cellule de base.

De préférence, la diminution et l'augmentation de la tension miroir est réalisée par une boucle de rétrocontrôle connectée à au moins l'un des noeuds internes de la ou des cellules miroir.

Avantageusement, le procédé selon l'invention peut également être mis en oeuvre lorsque la tension d'alimentation du dispositif est proche de la tension nominale.

Grâce à cette configuration, la détermination de la tension à appliquer à une colonne de base pour réaliser une opération peut être réalisée de manière dynamique, par une adaptation dynamique aux conditions PVT.

Le procédé selon l'invention est avantageusement mis en oeuvre à chaque opération d'écriture dans une colonne de base.

D'autres caractéristiques et avantages de la présente invention apparaîtront plus clairement à la lecture de la description suivante donnée à titre d'exemple illustratif et non limitatif, et faite en référence aux figures annexées dans lesquelles :
- la figure la est une représentation schématique d'une cellule SRAM classique,
- la figure 1b est une représentation schématique d'un mode de réalisation d'une partie du dispositif selon l'invention,
- la figure 2 est une représentation schématique d'un mode de réalisation d'une boucle de rétrocontrôle selon l'invention,
- la figure 3 est une représentation schématique de la dynamique des tensions en certains points du dispositif dans un mode de réalisation de l'invention,
- la figure 4 illustre un mode de réalisation du dispositif selon l'invention comprenant des moyens pour créer une surtension sur au moins une ligne de bits,
- la figure 5 illustre de manière plus détaillée certaines parties de la figure 4, et
- la figure 6 illustre la dynamique des tensions en certains points du dispositif comprenant des moyens pour créer une surtension sur au moins une ligne de bits selon l'invention.

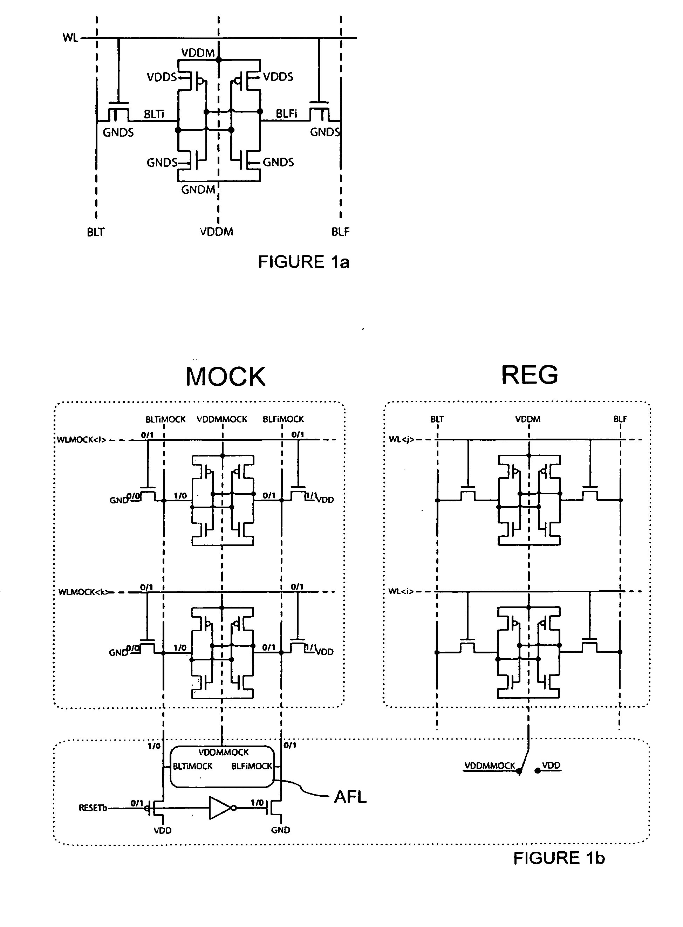

Une cellule SRAM est, comme représenté sur la figure 1a, classiquement composée de deux transistors d'accès et d'un verrou (latch), ou coeur, à quatre transistors, deux PMOS et deux NMOS formant deux inverseurs. Chaque inverseur a sa sortie connectée à l'entrée de l'autre inverseur.

Les deux transistors d'accès, dont le substrat est au potentiel de masse GNDS, sont activables par une ligne de sélection de mot WL. Le premier transistor d'accès est connecté à une ligne de sélection de bits BLT, et le deuxième transistor d'accès est connecté à une ligne de sélection de bits complémentaire BLF.

Le point de connexion entre le premier transistor d'accès et un premier couple de transistors (NMOS, PMOS) du coeur définit un premier noeud interne BLTi. Le point de connexion entre le deuxième transistor d'accès et le deuxième couple de transistors (NMOS, PMOS) du coeur définit un deuxième noeud interne BLFi complémentaire.

Dans la présente description, BLTi et BLFi définissent indifféremment les noeuds internes ou la valeur de la tension régnant respectivement en ces points.

La tension VDDM d'alimentation du coeur d'une cellule est au maximum égale à la tension VDD d'alimentation du dispositif.

Comme représenté sur la figure 1b, le dispositif de stockage d'informations à mémoire SRAM comprend une matrice de cellules de base, dont seules deux cellules d'une colonne de base REG sont représentées et sélectionnables par des lignes de sélection de mot WL<j> et WL<i>. Les cellules de base sont alimentées par une tension d'alimentation VDDM.

En outre, le dispositif comprend des moyens de variation de cette tension d'alimentation VDDM des cellules de base.

Ces moyens de variation comprennent au moins une colonne miroir MOCK. Cette colonne comprend au moins une cellule miroir. De préférence, la colonne miroir comprend une pluralité de cellules miroir. De préférence, le nombre de cellules miroir dans une colonne miroir est inférieur ou égal au nombre de cellules de base dans une colonne de base. La colonne miroir permet de simuler le comportement d'au moins une cellule de base d'une colonne de base.

Grâce à cette simulation, une opération d'écriture peut être réalisée à une tension optimale. Et le sous-voltage réalisé afin de favoriser l'écriture d'une cellule est le sous-voltage strictement nécessaire à cette opération, ce qui limite le risque d'exposer la cellule à sa tension de perte de rétention d'information.

Dans le mode de réalisation préféré de l'invention, les cellules miroir de la colonne miroir sont mises en parallèle par l'entremise de leurs noeuds internes. La mise en parallèle permet ainsi d'avoir une ligne BLTiMOCK et une ligne BLFiMOCK complémentaire reliant l'ensemble des cellules miroir d'une colonne miroir, les cellules miroir mises en parallèle étant sélectivement activées comme décrit ci-après.

Une opération d'écriture dans une cellule consiste à modifier l'état logique des noeuds internes de cette cellule. En cela, il s'agit de résoudre le conflit d'impédance entre les transistors d'accès et le verrou, de sorte à ce que les transistors d'accès réussissent a imposer la valeur du couple de tension (BLT, BLF) sur les noeuds internes respectifs (BLTi, BLFi).

Or, lors de la fabrication des dispositifs à cellules mémoires, il existe principalement deux types de dispersions venant perturber les propriétés des cellules.

Le premier type concerne la dispersion globale due au procédé technologique. L'effet consiste à devoir, pour réaliser une opération d'écriture, mettre en oeuvre des moyens d'écriture adaptatifs vis-à-vis des variations globales du procédé technologique (élément « P » des conditions PVT susmentionnées).

Le deuxième type concerne la dispersion locale, c'est-à-dire le comportement d'un transistor MOS par rapport à son voisin une fois ceux-ci intégrés en colonne, qui induit la logique de « maillon faible » sus-évoquée.

L'effet de ces déviations réside d'une part dans le fait qu'une opération d'écriture est favorisée en diminuant le potentiel VDDM d'alimentation d'une cellule, et d'autre part que la cellule la plus contraignante d'une colonne, c'est-à-dire la cellule présentant les conditions d'écriture les plus mauvaises, aussi appelée « pire cas », conditionne les conditions d'écriture pour toutes les autres cellules de la colonne.

L'un des objets de la présente invention consiste donc à simuler la cellule la plus contraignante d'une colonne de cellules de base dans une colonne miroir.

La cellule la plus contraignante est la cellule présentant les pires conditions d'écriture d'une colonne de base, typiquement celle requérant la plus basse tension VDDM d'alimentation lors d'une écriture.

Ainsi, selon l'invention, la simulation, dans une colonne miroir, de la cellule de base la plus contraignante d'une colonne de base permet de garantir que les autres cellules de base de la colonne de base seront correctement alimentées par la tension VDDM.

Autrement dit, la colonne miroir permet de déterminer la tension miroir VDDMMOCK qui équivaut à la tension VDDM la plus faible pour laquelle la cellule la plus contraignante d'une colonne de base donnée est capable de réaliser une opération d'écriture. Cette tension VDDMMOCK est alors appliquée, copiée, dans la colonne de base comprenant la cellule de base devant réaliser l'opération d'écriture.

De préférence, la cellule la plus contraignante est identifiée après la fabrication du dispositif lors des tests de tri électrique.

Elle peut également être identifiée *a priori*, par des moyens de simulation, ou encore de manière statistique.

L'émulation dans la colonne miroir permet de reproduire la cellule la plus contraignante d'une colonne de base.

Plusieurs modes de réalisation sont possibles. Seul le mode de réalisation préféré est illustré sur la figure 1b. Pour simplifier la présente description, la matrice de cellules de base est une matrice à une colonne de base REG, la colonne comprenant deux cellules. Le dispositif comprend en outre une colonne miroir MOCK de deux cellules miroir, susceptibles de simuler le comportement des cellules de base de la colonne de base

Dans ce mode de réalisation, les noeuds internes des cellules miroir sont mis en parallèle, par l'intermédiaire de deux lignes d'interconnexion des noeuds internes BLTiMOCK et BLFiMOCK complémentaires.

Pour chaque coeur de chaque cellule miroir, une paire de transistors d'accès est associée, ces cellules sont pilotées par une ligne de sélection de mots propre. Sur la figure 1b, les cellules miroir sont sélectivement activées par sélection de la ou des lignes à sélection de mot WLMOCK<1>, WLMOCK<k> de la colonne miroir.

La sélection du nombre de lignes de sélection de mot activées permet ainsi d'émuler des conditions plus ou moins difficile d'écriture. Par exemple, sur la figure 1b, si la ligne de sélection de mots WLMOCK<1> est à 0 (non sélectionnée) et la ligne de sélection de mots WLMOCK<k> est à 1 (sélectionnée), le conflit d'impédance a lieu entre deux transistors d'accès et deux verrous donc huit transistors.

On peut ainsi sous exploiter le nombre de transistors d'accès qui viennent piloter un nombre fixé de coeurs, et ainsi rendre les conditions d'écriture plus ou moins difficiles.

Le mode de réalisation illustré sur la figure 1b comprend également une ligne de transistors pilotés par un signal de commande RESETb. Cette commande permet de forcer les conditions initiales sur les lignes d'interconnexion des noeuds internes BLTiMOCK et BLFiMOCK, comme décrit ci-dessous.

Dans ce mode de réalisation, les conditions initiales pour une cellule miroir sont telles que la ligne d'interconnexion des noeuds internes BLTiMOCK est à 1 et la ligne d'interconnexion des noeuds internes BLFiMOCK est à 0. Le transistor d'accès connecté à la ligne BLTiMOCK est à la masse GND, tandis que l'autre transistor d'accès, relié à la ligne BLFiMOCK, est connecté à l'alimentation du circuit VDD.

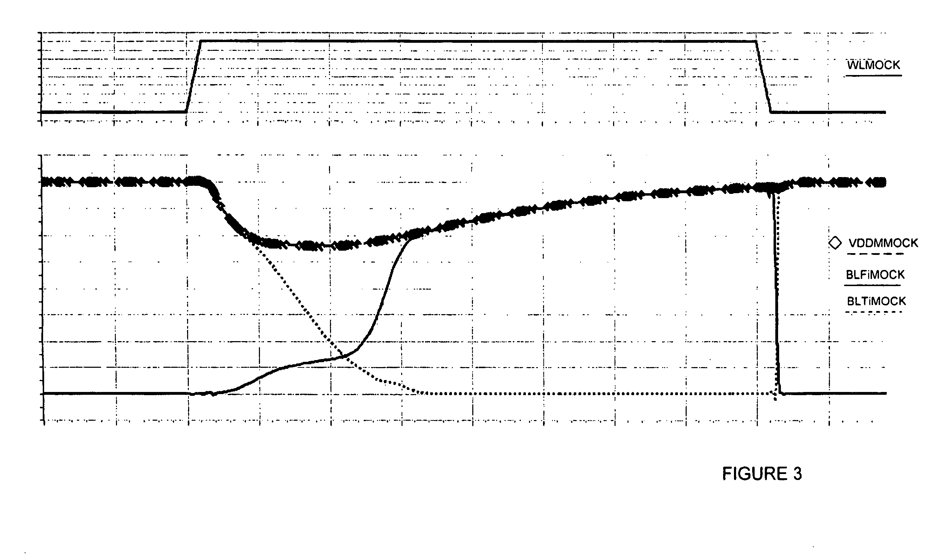

Lorsqu'une opération d'écriture est réalisée, la ligne BLTiMOCK est à 0, tandis que la ligne BLFiMOCK est à 1. Il est dans ce cas nécessaire de réinitialiser les conditions initiales (BLTiMOCK à 1, et BLFiMOCK à 0) en vue d'une prochaine opération d'écriture. Cette réinitialisation est également illustrée par les variations brusques des tensions correspondantes en fin de cycle de la figure 3.

Cette étape de réinitialisation est consommatrice de courant. A titre d'alternative, elle peut être remplacée par une alternance des potentiels sur les transistors d'accès. Dans ce cas, le transistor d'accès connecté à la ligne BLTiMOCK est alors à l'alimentation du circuit VDD, tandis que l'autre transistor d'accès, relié à la ligne BLFiMOCK, est connecté à la masse GND. Une nouvelle opération d'écriture amenant ensuite une nouvelle alternance des potentiels.

Dans le mode de réalisation préféré, on définit par N le nombre de transistors d'accès activés, et par P le nombre de cellules miroir mises en parallèle activées. Le ratio N/P dépend avantageusement de la tension d'alimentation VDD du dispositif.

De préférence, pour des transistors de technologie 65nm, le ratio N/P est de 2/16 pour une tension VDD de 0,7V. Ce ratio tend vers 1 quand la tension VDD d'alimentation du dispositif tend vers la tension nominale (1,2V dans ce cas). Un autre ratio peut être déterminé par tests statistiques.

Dans le mode de réalisation préféré, les cellules miroir sont identiques aux cellules de base, ce qui simplifie la fabrication du dispositif. De préférence, la colonne miroir est adjacente à la matrice de base.

Un deuxième mode de réalisation peut remplacer ou être combiné au premier mode de réalisation décrit ci-avant.

La différence d'impédance entre les transistors du coeur d'une cellule et ses transistors d'accès peut également être réalisée par différence entre les tensions de seuil respectives.

A cet effet, pour rendre les conditions d'écriture plus difficiles sur les cellules d'une colonne miroir, la tension de seuil des transistors d'accès de la ou des cellule(s) miroir est avantageusement supérieure à celle des transistors d'accès d'une cellule de base.

Parallèlement, on peut prévoir, en outre ou à titre d'alternative, que la tension de seuil des transistors du verrou de la ou des cellule(s) miroir soit inférieure à celle des transistors du verrou de la cellule de base.

De préférence, la différence entre les tensions de seuil est de 6σ, σ étant l'écart type de la tension de seuil des transistors utilisés. Avantageusement, les tensions de seuil des transistors du coeur et des transistors d'accès sont respectivement diminuées de 3σ et augmentées de 3σ.

Les tensions de seuil sont modifiées, par exemple, par implantation ionique, par levier électrique, ou par modification des dimensions, soit la largeur W du canal, et/ou sa longueur L.

Les conditions représentatives de la cellule la plus contraignante étant simulées dans la colonne miroir, la tension VDDMMOCK d'alimentation des coeurs des cellules miroir est alors progressivement diminuée jusqu'à détecter l'écriture dans les cellules miroir activées.

Cette opération de variation de la tension VDDMMOCK d'alimentation des cellules miroir est réalisée par une boucle de rétrocontrôle.

La boucle de rétrocontrôle est connectée à au moins l'un des noeuds internes BLTiMOCK, BLFiMOCK des cellules de la colonne miroir. Et de préférence, comme représenté sur la figure 1b, la boucle de rétrocontrôle est connectée aux deux noeuds internes BLTiMOCK, BLFiMOCK.

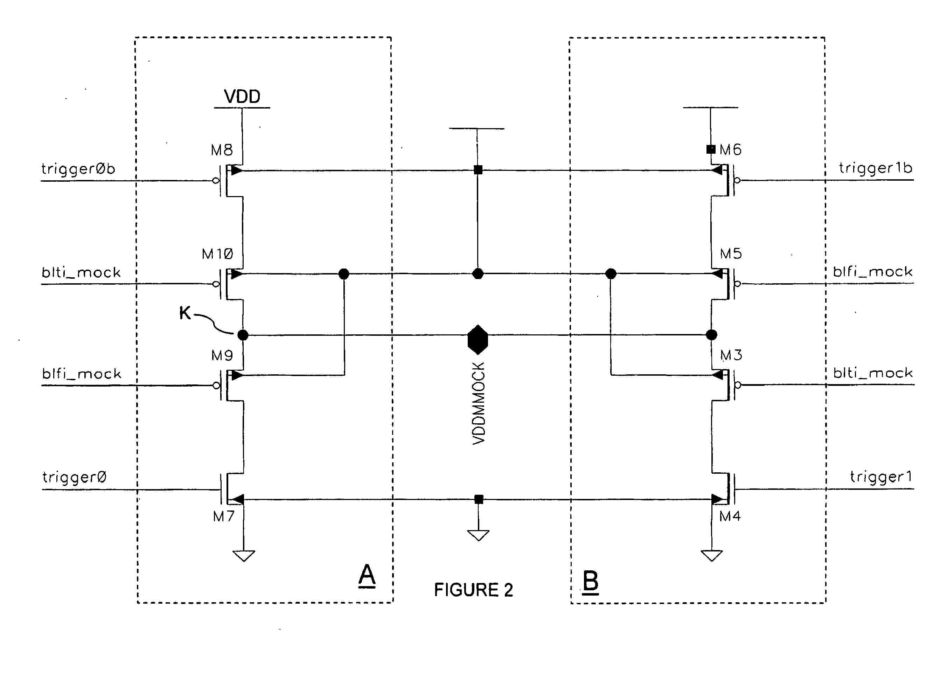

Le mode de réalisation préféré d'une boucle de rétrocontrôle AFL est représenté sur la figure 2.

Dans ce mode de réalisation préféré, la boucle de rétrocontrôle comprend une structure symétrique, représentée par les deux branches A et B de la figure 2. Aussi pour simplifier la présente description, seule la branche A peut être décrite.

La branche A comprend quatre transistors en série. Le premier transistor M8 (PMOS) a sa source connectée à VDD l'alimentation du dispositif. De manière symétrique, le quatrième transistor M7 (NMOS) a sa source connectée à la masse. Ces transistors sont commandés respectivement par des signaux de commande trigger0b et trigger0 complémentaires. Ces transistors permettent la sélection de la branche A et participent au chemin respectivement de charge et de décharge, comme décrit ultérieurement.

Le deuxième transistor M10 (PMOS) et le troisième transistor M9 (PMOS) permettent de générer la variation de tension VDDMMOCK de la colonne miroir, grâce au point de contact K entre la source d'alimentation VDDMMOCK et les transistors M9 et M10, comme décrit ci-après.

Ces transistors M9 et M10 sont respectivement commandés par les tensions de commande BLFiMOCK et BLTiMOCK décrites auparavant.

Pour simplifier la présente description, seul le cas où, en début de cycle, la valeur logique de BLFiMOCK est égale à 0 et celle de BLTiMOCK est égale à 1, est décrit ci-après.

Ces conditions initiales arbitraires sont opposées pour les transistors M3 et M5. La mise en oeuvre de cette branche B nécessite, par ailleurs, l'activation des transistors M4 et M6 grâce aux signaux trigger1 et trigger1b respectivement.

Il faut noter qu'un autre mode de réalisation consiste à alterner les phases d'utilisation des branches A et B. Cela tend à minimiser la consommation de puissance dynamique absorbée par la colonne miroir.

A l'instant initial, la tension de la colonne miroir VDDMMOCK est égale à la tension de l'alimentation du circuit VDD. Le transistor M9 est passant et le transistor M10 est bloqué. Or, le transistor M7 est passant, il existe donc un chemin de décharge de VDDMMOCK à la masse.

Cette disposition permet de faire varier, à la baisse, la tension VDDMMOCK de manière progressive.

Le choix du dimensionnement des transistors de la branche permet de régler la pente de décharge (ou de charge comme décrit ci-après). Si la pente de décharge est trop faible, le temps d'écriture risque d'être trop long, et si la pente de décharge est trop abrupte, la tension VDDMMOCK risque de descendre en-deçà de la valeur minimale de la tension de rétention. De préférence, le dimensionnement des transistors de la branche est fonction de la capacité totale équivalente au noeud VDDMMOCK.

Comme représenté sur la figure 3, une cellule miroir est activée par l'application d'une tension de commande sur sa ligne de sélection de mots WLMOCK correspondante. Cette figure représente de manière synchrone, selon un temps arbitraire, la variation des tensions suivantes :
- la tension de commande d'une cellule miroir WLMOCK,
- la tension d'alimentation VDDMMOCK de la cellule miroir sélectionnée par la commande WLMOCK,
- la tension BLFiMOCK au noeud interne correspondant de cette cellule miroir sélectionnée,
- la tension BLTiMOCK au noeud interne correspondant de cette cellule miroir sélectionnée.

A l'amorce d'écriture, la tension VDDMMOCK diminue progressivement, ce qui favorise l'opération d'écriture. Parallèlement, la tension BLFiMOCK augmente progressivement et la tension BLTiMOCK diminue progressivement.

Lorsque l'opération d'écriture est réussie (bascule du coeur des cellules), les valeurs logiques BLTiMOCK et BLFiMOCK sont inversées par rapport à leur valeur initiale, ainsi la valeur logique de BLFiMOCK est égale à 1 et celle de BLTiMOCK est égale à 0.

De manière similaire au chemin de décharge, le transistor M9 s'éteint progressivement et le transistor M10 s'allume progressivement. Or le transistor M8 est déjà passant. Il existe donc un chemin conducteur (recharge) entre la tension VDDMMOCK et la tension VDD, pour ramener progressivement la tension de la cellule VDDMMOCK à la tension d'alimentation du dispositif VDD une fois l'opération d'écriture réalisée.

Cette disposition permet de faire varier, à la hausse, la tension VDDMMOCK de manière progressive. De même que pour le chemin de décharge, le dimensionnement des transistors permet d'influer sur la pente de charge.

La tension VDDMMOCK pour laquelle l'émulation de la cellule de base présentant les pires conditions d'écriture de la colonne de base bascule peut alors être recopiée dans la colonne de base émulée, soit par un lien direct tel que représenté sur la figure 1b, auquel cas la tension VDDMMOCK est appliquée dès le début à la colonne de base, soit par un dispositif interrupteur.

Une opération d'écriture porte généralement sur un ensemble de cellules de base. De préférence, la tension VDDM d'alimentation de ces cellules de base est, dès le début du cycle d'écriture, égale à la tension d'alimentation des cellules miroir VDDMMOCK, ce qui évite des problèmes de redistribution de charges dues aux capacités parasites que représentent les cellules de base en colonnes. Les autres cellules de la matrice sont alimentées par la tension VDD du dispositif.

Une fois l'opération d'écriture réalisée dans la colonne de base, l'alimentation de la colonne de base VDDM est à nouveau à une tension de lecture ou de repos VDD, ce qui équivaut à faire basculer l'interrupteur de la figure 1b vers l'alimentation VDD du dispositif. L'interrupteur est avantageusement piloté par le changement d'état logique des lignes de connexion BLTiMOCK, BLFiMOCK.

Toutefois, pour une cellule de base dans une colonne de base, lorsque la tension VDDM varie, notamment par la recopie de la tension VDDMMOCK, toutes les cellules de base de la colonne de base étant alimentées par cette tension VDDM, même les cellules qui ne sont pas adressées subissent cette variation.
Il existe donc un risque que la tension d'alimentation VDDM atteigne la valeur de la tension de rétention pour une ou plusieurs cellules non adressées, avec les risques de perte d'information associés, comme vu précédemment.

Pour limiter ce risque, et favoriser les opérations d'écriture, l'invention concerne également un autre mode de réalisation dans lequel l'invention comprend en outre des moyens pour créer une surtension sur au moins une ligne de bits.

Ce mode de réalisation est combinable aux autres modes de réalisation précédemment décrits.
Toutefois, ce mode de réalisation peut être mis en oeuvre en combinaison avec la variation de la tension d'alimentation VDDM de la colonne de base d'une cellule de base sélectionnée pour le stockage d'informations, sans obligatoirement que celle-ci soit mise en oeuvre par les moyens d'émulation précédemment décrits.

Grâce à la surtension sur au moins une ligne de bits, la tension d'alimentation VDDM de la colonne de base sélectionnée (éventuellement émulée) associée à cette ligne de bits n'a pas besoin de descendre aussi bas qu'en l'absence de la surtension, ce qui limite ainsi les risques d'atteindre la valeur de la tension de rétention.

C'est-à-dire qu'on peut définir VDDM_min, la tension d'alimentation minimale sur la colonne de base sélectionnée pour permettre une opération d'écriture lorsque les moyens de surtension ne sont pas mis en oeuvre, et VDDM_min_boost la tension minimale sur la colonne de base sélectionnée pour permettre une opération d'écriture lorsque les moyens de surtension sont mis en oeuvre.
A titre d'exemple, pour certaines mémoires, la valeur de la tension de rétention Vret est Vret = 0,7 V. Pour garantir la retention, on doit avoir VDDM_min >= Vret. Si la baisse de tension δVDDM nécessaire à une opération d'écriture (lorsque les moyens de surtension ne sont pas mis en oeuvre) est de 200mV, la tension minimale d'alimentation VDD_min est alors égale à VDD_min = Vret + δVDDM, soit VDD_min = 0,9 V.
Lorsque les moyens de surtension sont mis en oeuvre, on a δVDDM_boost la baisse de tension nécessaire à une opération d'écriture.
Pour une cellule donnée, on a δVDDM_boost < δVDDM, c'est-à-dire que pour une même cellule la baisse de tension nécessaire à une opération d'écriture lorsque les moyens de surtension sont mis en oeuvre est inférieure à celle nécessaire à une opération d'écriture lorsque les moyens de surtension ne sont pas mis en oeuvre.
En l'espèce, pour la cellule mentionnée ci-dessus, la baisse de tension nécessaire à une opération d'écriture lorsque les moyens de surtension sont mis en oeuvre est δVDDM_boost = 100mV.
Ainsi, dans cet exemple, pour une tension d'alimentation VDD_min de 0,9V, on a VDDM_min_boost = VDD_min
- δVDDM_boost, soit VDDM_min_boost = 0,8V. Ce qui est supérieur à la tension de rétention Vret = 0,7 V.
   Alternativement, la mise en oeuvre des moyens de surtension permet de conserver une valeur de tension minimale VDDM_min_boost égale à la tension de rétention Vret, et par conséquent d'alimenter la cellule à une tension d'alimentation VDD_min = 0,8V.
   La mise en oeuvre des moyens de surtension permet donc de configurer le dispositif de stockage d'information à mémoire vive soit en baissant la tension d'alimentation VDD, soit en augmentant la tension minimale VDDM_min nécessaire à une opération d'écriture (VDDM_min_boost > VDDM_min).
   Toutefois, la génération de tensions négatives est de préférence limitée en amplitude (déclenchement parasite de diodes). De plus, si on considère l'ensemble des configurations de cellules mémoires difficiles à écrire, il apparaît que l'écriture de certaines est facilitée de façon plus optimale par les moyens d'émulation, alors que l'écriture d'autres cellules est facilitée de façon plus optimale par la mise en oeuvre des moyens de surtension.
   La présente invention combine donc avantageusement les deux moyens susmentionnés.

Grâce à l'invention, on peut donc créer des mémoires fonctionnant à des tensions d'alimentation VDD encore plus basses puisque la baisse de tension pour faciliter les opérations d'écriture est moindre du fait de la surtension négative sur au moins une ligne de bits.

Le dispositif de stockage d'information à mémoires de type SRAM selon l'invention est de préférence une mémoire de type hiérarchique et paginée, c'est-à-dire comprenant un ensemble de sous-blocs constitutifs dans lesquels sont dérivées les lignes de bits.

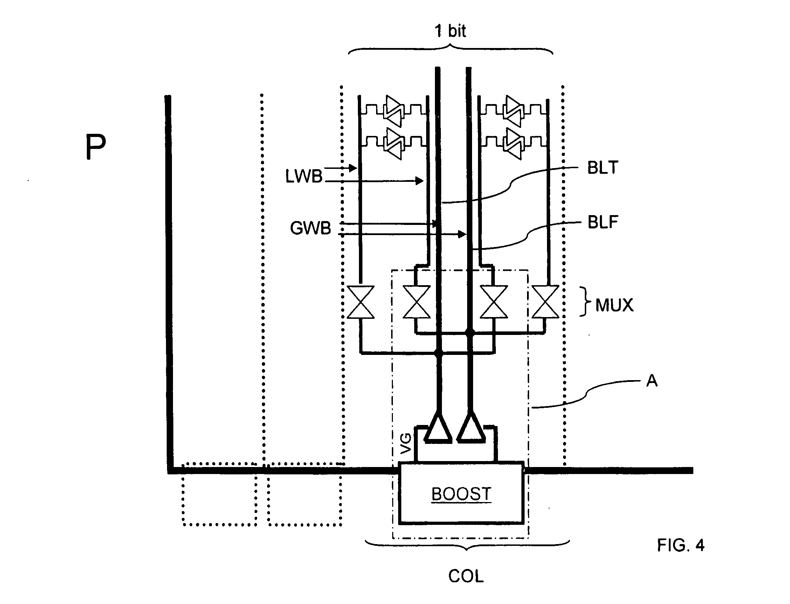

La figure 4 illustre schématiquement un tel type de mémoire, la zone P représentant la périphérie du dispositif.
L'organisation multiplexée de la mémoire permet de répartir les sous-blocs selon des configurations particulières. Ainsi une colonne COL au sens de la présente invention correspond physiquement à un ensemble d'une ou plusieurs colonnes multiplexées par des moyens de multiplexage MUX se situant de préférence au niveau local, c'est-à-dire des sous-blocs.
Dans cette configuration, le dispositif de stockage d'information à mémoires comprend des lignes de bits BLT, BLF au niveau global GWB, qui sont distribuées par les moyens de multiplexage au niveau local LWB.
Par souci de clarté, la figure 4 n'illustre qu'une paire de lignes de bits BLT, BLF au niveau global et que quatre cellules de base. La configuration illustrée est reproductible sur d'autres colonnes de base, illustrées par des pointillés.

De préférence, chaque bit d'information du dispositif de stockage est associé à une paire de lignes de bits BLT, BLF, et associé à des moyens pour créer une surtension BOOST sur au moins une ligne de bits respectifs.
Selon l'invention, on associe les moyens pour créer une surtension BOOST sur au moins une ligne de bits au niveau global.

Les moyens pour créer une surtension BOOST sont reliés à au moins une ligne de bits par une ligne de connexion VG (pour masse virtuelle).

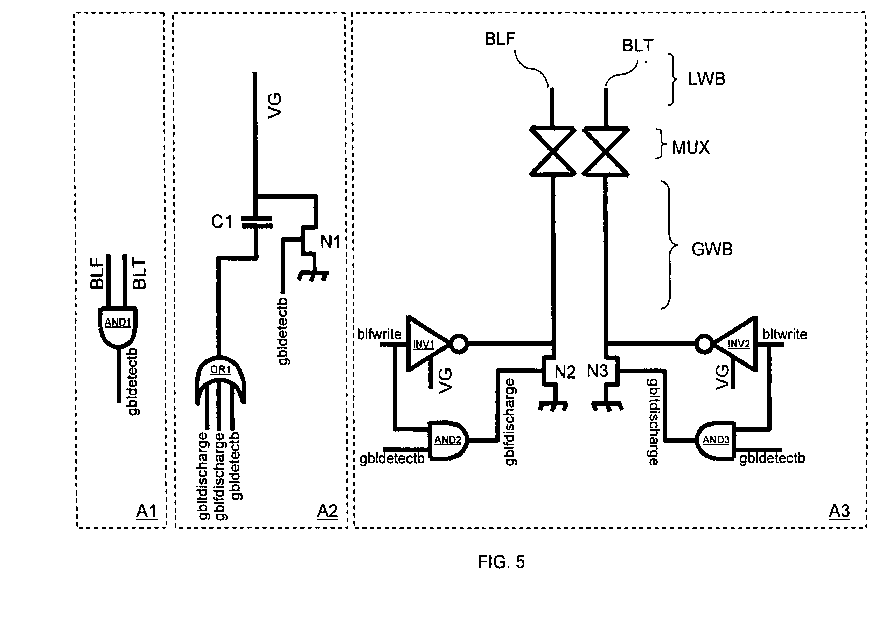

La figure 5 illustre plus précisément une partie de la zone A de la figure 4.

Pour plus de clarté, la zone A de la figure 4 est subdivisée en 3 sous-zones A1, A2 et A3. Les sous-zones sont reliées entre elles par l'intermédiaire de lignes de connexion. Ainsi, une ligne de connexion commune à plusieurs sous-zones porte le même nom dans chaque sous-zone concernée.

Pour rappel, pour une opération d'écriture, les deux lignes de bits BLT, BLF sont d'abord toutes les deux préchargées à 1 et l'une ou l'autre est amenée à 0 selon que la valeur à écrire est un 1 ou un 0 logique. Cette mise à 0 d'une ligne de bits BLF, BLT est effectuée grâce à un transistor, en l'espèce NMOS, respectivement N2 ou N3 dans le sous-bloc A3.
A un premier niveau (sous-zone A1), les lignes de bits BLT, BLF sont connectées en entrée d'une porte ET logique AND1. La porte AND1 permet de détecter le passage à 0 d'une des deux lignes de bits puisqu'elle génère un signal de sortie gbldetectb dont la valeur passe à 0 lorsque l'une des deux lignes de bits passe à 0.
On entend indistinctement le nom de la ligne ou le nom du signal transitant sur cette ligne.
De préférence, cette porte AND1 a un seuil de déclenchement relativement bas afin de détecter le passage à 0 le plus tardivement possible.
Lorsque le signal de sortie gbldetectb est à 0, celui-ci coupe la précharge (transistor NMOS N1 du sous-bloc A2) sur la capacité C1. De même, il coupe les transistors N2 et N3 (sous-blocs A3) via les portes AND2 et AND3 respectivement et les lignes de connexion gblfdischarge et gbltdischarge respectivement.
Par ailleurs, le signal de sortie gbldetectb est également relié en entrée d'une porte OU à trois entrées OR1 (sous-bloc A2) dont les deux autres sont constituées des signaux gblfdischarge et gbltdischarge.
La sortie de la porte OR1 est reliée à l'une des bornes de la capacité C1.
L'autre borne de la capacité C1 est reliée au transistor N1 (sous-bloc A2) et génère le signal VG (masse virtuelle).
Le signal VG est distribué aux inverseurs INV1 et INV2 (sous-bloc A3) dont les signaux d'entrée blfwrite et bltwrite respectivement sont les signaux de commande qui définissent l'écriture d'un 1 ou d'un 0 logique.
Les moyens BOOST pour créer une surtension, en l'espèce négative, sont activés lorsque les trois entrées de la porte OR1 sont à 0 : les connections entre lignes de bits au niveau global GWB distribuées au niveau local LWB et la masse sont coupées au moments de la mise en oeuvre des moyens de surtension pour avoir une efficacité maximale. En liaison avec la figure 4, les moyens BOOST de la figure 4 correspondent sensiblement au sous-bloc A2 de la figure 5.

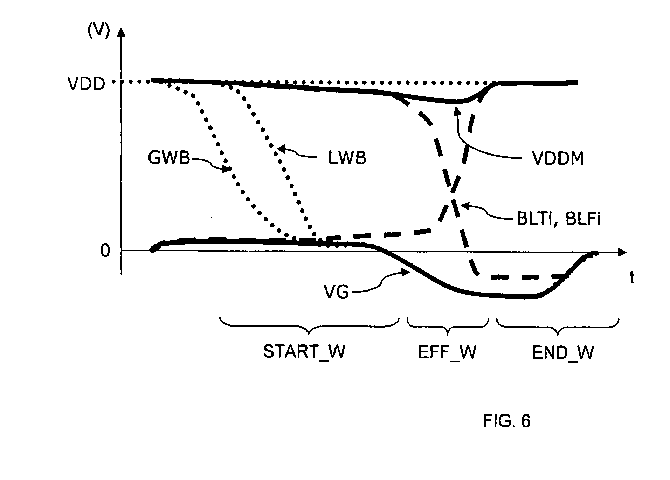

Sur le plan dynamique, figure 6, on a représenté l'évolution de la tension en Volts (V) de plusieurs signaux selon un temps t arbitraire pour une cellule difficile à écrire.
Le signal GWB correspond à la tension sur la ligne de bit impactée par une opération d'écriture au niveau global (l'autre restant à la valeur de VDD).

Le signal LWB correspond à la tension sur la ligne de bit impactée par une opération d'écriture au niveau local. Le décalage temporel entre les signaux GWB et LWB est du au multiplexage MUX.
Dans une première phase START_W correspondant au début de l'écriture, la ligne de bit impactée (GWB, LWB) par l'opération d'écriture passe à 0, et la tension d'alimentation de la cellule VDDM commence à diminuer.
Lorsque la ligne de bit est à 0, cette valeur est détectée, comme vu précédemment, et le signal VG passe dans les valeurs négatives, ce qui facilite les opérations d'écriture.
Dans une deuxième phase EFF_W, l'écriture a effectivement lieu (bascule des noeuds internes de la cellule BLTi, BLFi), et la tension d'alimentation de la cellule VDDM atteint son minimum VDDM_min.
Dans une troisième phase, END_W, l'écriture se termine : la tension d'alimentation de la cellule VDDM revient à la valeur de la tension d'alimentation VDD, et la valeur du signal VG revient à 0.

## Revendications

1. Dispositif de stockage d'informations à mémoires de type SRAM, alimenté par une tension (VDD), et comprenant :
- une matrice de cellules de base, organisées en colonnes de base et alimentées par une tension d'alimentation (VDDM), et
- des moyens de variation de la tension d'alimentation (VDDM) de la colonne de base d'une cellule de base sélectionnée pour le stockage d'informations,
les moyens de variation de la tension d'alimentation (VDDM) d'une colonne de base comprenant :
- des moyens d'émulation, dans une colonne miroir comprenant au moins une cellule miroir munie de noeuds internes (BLTiMOCK, BLFiMOCK), de la cellule la plus contraignante en écriture de la colonne de base comprenant la cellule de base sélectionnée,
- des moyens de variation de la tension d'alimentation miroir (VDDMMOCK) de la colonne miroir, et
- des moyens pour recopier la tension d'alimentation miroir (VDDMMOCK) dans la colonne de base comprenant la cellule de base sélectionnée, à la détection du basculement de l'ensemble d'au moins une cellule miroir dans la colonne miroir.

2. Dispositif selon la revendication 1, dans lequel la colonne miroir comprend au moins une autre cellule miroir de sorte à constituer une pluralité P de cellules miroir mises en parallèle et un nombre N de transistors d'accès miroirs activés, et dans lequel le rapport N/P entre le nombre de transistors d'accès miroirs activés et le nombre de cellules miroir mises en parallèle est fonction de la tension d'alimentation du dispositif de stockage (VDD).

3. Dispositif selon l'une quelconque des revendications précédente, dans lequel les moyens de variation de la tension d'alimentation miroir (VDDMMOCK) comprennent une boucle de rétrocontrôle connectée à au moins l'un des noeuds internes (BLTiMOCK, BLFiMOCK).

4. Dispositif selon l'une quelconque des revendications précédentes, dans lequel au moins une cellule miroir de la colonne miroir est une cellule SRAM comprenant des transistors d'accès et des transistors de coeur, dont la tension de seuil d'au moins l'un d'entre eux est différente de la tension de seuil d'un transistor de même type d'une cellule de base.

5. Dispositif selon l'une quelconque des revendications précédentes, comprenant en outre des moyens (BOOST) pour créer une surtension sur au moins une ligne de bits.

6. Dispositif selon la revendication 5, dans lequel chaque bit d'information est associé à une paire de lignes de bits (BLT, BLF), et associé à des moyens pour créer une surtension (BOOST) sur au moins une ligne de bits respectifs.

7. Procédé de mise en oeuvre d'un dispositif de stockage d'informations à mémoires SRAM, organisées en matrice de cellules de base, comprenant les étapes consistant à :
- sélectionner une cellule de base d'une colonne de base pour le stockage d'informations,
- émuler, dans une colonne miroir comprenant au moins une cellule miroir munie de noeuds internes (BLTiMOCK, BLFiMOCK), la cellule la plus contraignante de la colonne de base comprenant la cellule de base sélectionnée,
- appliquer à la colonne miroir une tension d'alimentation miroir (VDDMMOCK) initiale,
- diminuer progressivement la tension miroir initiale (VDDMMOCK) jusqu'à détecter le basculement de l'ensemble d'au moins une cellule miroir dans la colonne miroir,
- copier dans la colonne de base la tension miroir, et
- augmenter ensuite progressivement la tension d'alimentation miroir (VDDMMOCK) jusqu'à la tension initiale.

8. Procédé selon la revendication 7, dans lequel l'étape d'émulation comprend la mise en parallèle d'une pluralité P de cellules miroir, et dans lequel les cellules miroir mises en parallèle sont sélectivement activées par N transistors d'accès.

9. Procédé selon l'une quelconque des revendications 7 à 8, dans lequel l'étape d'émulation comprend, pour au moins un transistor d'au moins une cellule miroir, la réalisation d'une tension de seuil différente de celle d'un transistor de même type d'une cellule de base.

10. Procédé selon l'une quelconque des revendications 7 à 9, dans lequel la diminution et l'augmentation de la tension miroir est réalisée par une boucle de rétrocontrôle connectée à au moins l'un des noeuds internes (BLTiMOCK, BLFiMOCK).

11. Procédé selon l'une quelconque des revendications 7 à 10, comprenant en outre une étape consistant à créer une surtension sur au moins une ligne de bits, ladite ligne de bits étant préalablement mise à 0.

## Claims

1. The SRAM type memory information storage device, powered by a voltage (VDD), and comprising :
- an array of base cells, organised in base columns and powered by a power supply voltage (VDDM), and
- means for varying the power supply voltage (VDDM) for the base column for a base cell selected for information storage,
the means for varying the power supply voltage (VDDM) for a base column comprising :
- emulation means, in a mirror column comprising at least one mirror cell provided with internal nodes (BLTiMOCK, BLFiMOCK), for the cell wich is the most restricting in writing in the base column comprising the selected base cell,
- means of varying the mirror power supply voltage (VDDMMOCK) for the mirror column, and
- means for copying the mirror power supply voltage (VDDMMOCK) in the base column comprising the selected base cell, when detecting the switching of the set of at least one mirror cell in the mirror column.

2. The device according to claim 1, wherein the mirror column comprises at least one other mirror cell so as to constitute a plurality P of mirror cells placed in parallel and a number N of activated mirror access transistors, and in which the ratio N/P between the number of activated mirror access transistors and the number of mirror cells placed in parallel depends on the power supply voltage (VDD) for the storage device.

3. The device according to any one of the previous claims, wherein the means of varying the mirror power supply voltage (VDDMMOCK) comprise a feedback loop connected to at least one of the internal nodes (BLTiMOCK, BLFiMOCK) .

4. The device according to any one of the previous claims, wherein at least one mirror cell in the mirror column is an SRAM cell comprising access transistors and core transistors, for which the threshold voltage of at least one of them is different from the threshold voltage of a transistor of the same type in a base cell.

5. The device according to any one of the previous claims, further comprising means (BOOST) for creating an overvoltage on at least one line of bits.

6. The device according to claim 5, wherein each information bit is associated with a pair of lines of bits (BLT, BLF) and associated with means for creating an overvoltage (BOOST) on at least one line of respective bits.

7. The method for implementing an SRAM memory information storage device, said SRAM memories being organised in an array of base cells, comprising the steps of :
- selecting a base cell in a base column for information storage,
- emulating, in a mirror column comprising at least one mirror cell provided with internal nodes (BLTiMOCK, BLFiMOCK), the most restricting cell in the base column comprising the selected base cell,
- applying to the mirror column an initial mirror power supply voltage (VDDMMOCK),
- gradually decreasing the initial mirror voltage (VDDMMOCK) until detecting the switching of the set of at least one mirror cell in the mirror column,
- copying the mirror voltage in the base column, and
- then gradually increasing the mirror power supply voltage (VDDMMOCK) up to the initial voltage.

8. The method according to claim 7, wherein the emulation step comprises placing a plurality P of mirror cells in parallel and wherein the mirror cells placed in parallel are selectively activated by N access transistors.

9. The method according to any one of the claims 7 to 8, wherein the emulation step comprises, for at least one transistor for at least one mirror cell, the creation of a threshold voltage which is different from that for a transistor of the same type in a base cell.

10. The method according to any one of the claims 7 to 9, wherein the decrease and increase in the mirror voltage are achieved by a feedback loop connected to at least one of the internal nodes (BLTiMOCK, BLFiMOCK).

11. The method according to any one of the claims 7 to 10, further comprising a step consisting of creating an overvoltage on at least one line of bits, said line of bits being set to 0 beforehand.

## Patentansprüche

1. Vorrichtung zur Speicherung von Informationen auf SRAM-Speichern, die mit einer Spannung (VDD) versorgt wird, und mit:
- einer Matrix aus Basiszellen, die in Basisspalten organisiert sind und die mit einer Vorsorgungsspannung (VDDM) versorgt werden, und
- einer Basisspalte einer für die Speicherung von Informationen ausgewählten Basiszelle,
wobei die Variationseinrichtung der Versorgungsspannung (VDDM) einer Basisspalte umfasst:
- eine Emulationseinrichtung, in einer Spiegelspalte mit wenigstens einer mit internen Knoten (BLTiMOCK, BLFiMOCK) versehenen Spiegelzelle, der beim Schreiben der die gewählte Basiszelle umfassenden Basisspalte am stärksten beanspruchten Zelle,
- eine Variationseinrichtung der Spiegel-Versorgungsspannung (VDDMMOCK) der Spiegelspalte, und
- eine Einrichtung zum Rückkopieren der Spiegel-Versorgungsspannung (VDDMMOCK) in die Basisspalte, welche die gewählte Basiszelle umfasst, bei der Detektion des Kippens der Gesamtheit wenigstens einer Spiegelzelle in der Spiegelspalte.

2. Vorrichtung nach Anspruch 1, in welcher die Spiegelspalte wenigstens eine weitere Spiegelzelle umfasst, um so eine Mehrzahl P von Spiegelzellen zu bilden, die parallel angeordnet sind, und eine Anzahl N von Transistoren für einen Zugriff auf aktive Spiegel, und in welcher das Verhältnis N/P zwischen der Anzahl von Transistoren für den Zugriff auf aktive Spiegel und der Anzahl von parallel angeordneter Spiegelzellen abhängig ist von der Versorgungsspannung der Speichervorrichtung (VDD).

3. Vorrichtung nach einem der vorhergehenden Ansprüche, in welcher die Variationseinrichtung der Spiegel-Versorgungsspannung (VDDMMOCK) eine RetroKontrollschleife umfasst, die mit wenigstens einem der internen Knoten (BLTiMOCK, BLFiMOCK) verbunden ist.

4. Vorrichtung nach einem der vorhergehenden Ansprüche, in welcher wenigstens eine Spiegelzelle der Spiegelspalte eine SRAM-Zelle mit Zugriffstransistoren und Kerntransistoren ist, deren Grenzspannung wenigstens untereinander unterschiedlich ist von der Grenzspannung eines Transistors gleichen Typs einer Basiszelle.

5. Vorrichtung nach einem der vorhergehenden Ansprüche, mit einer weiteren Einrichtung (BOOST), um auf wenigstens einer Bitleitung eine Überspannung zu erzeugen.

6. Vorrichtung nach Anspruch 5, in welcher jede Bitinformation einem Paar von Bitlinien (BLT, BLF) zugeordnet ist und der Einrichtung zum Erzeugen einer Überspannung (BOOST) auf wenigstens einer jeweiligen Bitleitung zugeordnet ist.

7. Verfahren zum Herstellen einer Vorrichtung zur Speicherung von Informationen auf SRAM-Speichern, die in einer Matrix aus Basiszellen organisiert sind, mit den Schritten bestehend aus:
- Auswählen einer Basiszelle aus einer Basisspalte für die Speicherung von Informationen,
- Emulieren der am meisten beanspruchten Zelle der Basisspalte, welche die gewählte Basiszelle enthält, in einer Spiegelspalte mit wenigstens einer Spiegelzelle, die mit internen Knoten (BLTiMOCK), BLFiMOCK) versehen ist,
- Anlegen an die Spiegelspalte einer anfänglichen Spiegel-Versorgangsspannung (VDDMMOCK),
- progressives Vermindern der anfänglichen Spiegel-Versorgungsspannung (VDDMMOCK), bis das Kippen der Gesamtheit wenigstens einer Spiegelzelle in der Spiegelspalte detektiert wird,
- Kopieren der Spiegelspannung in die Basisspalte, und
- dann progressives Erhöhen der Spiegel-Versorgungsspannung (VDDMMOCK), bis zur anfänglichen Spannung.

8. Verfahren nach Anspruch 7, in welchem der Emulationsschritt die parallele Anordnung einer Mehrzahl P von Spiegelzellen umfasst und in welchem die parallel angeordneten Spiegelzellen selektiv durch N-Zugriffstransistoren aktiviert werden.

9. Verfahren nach einem der Ansprüche 7 bis 8, in welchem der Emulationsschritt für wenigstens einen Transistor wenigstens einer Spiegelzelle die Realisation einer Schwellenspannung umfasst, die von derjenigen eines Transistors des gleichen Typs einer Basiszelle unterschiedlich ist.

10. Verfahren nach einem der Ansprüche 7 bis 9, in welchem die Verminderung und Erhöhung der Spiegelspannung durch eine Retrokontrollschleife realisiert wird, die mit wenigstens einem der internen Knoten (BLTiMOCK, BLFiMOCK) verbunden ist.

11. Verfahren nach einem der Ansprüche 7 bis 10, mit wenigstens einem Schritt bestehend aus einem Erzeugen einer Überspannung auf wenigstens einer Bitleitung, wobei die Bitleitung auf 0 voreingestellt ist.
